# EUROPÄISCHE PATENTSCHRIFT

(11) **EP 3 327 796 B1**
(45) Veröffentlichungstag und Bekanntmachung des Hinweises auf die Patenterteilung: **29.03.2023**
(21) Anmeldenummer: 17207707.5
(22) Anmeldetag: 19.01.2009
(51) Int. Cl.: H01L 33/00, H01L 33/10, H01L 25/075, H01L 33/40

(54) **OPTOELEKTRONISCHES BAUELEMENT UND VERFAHREN ZUR HERSTELLUNG EINES OPTOELEKTRONISCHEN BAUELEMENTS**
OPTICAL-ELECTRONIC COMPONENT AND METHOD FOR PRODUCTION THEREOF
COMPOSANT OPTOÉLECTRONIQUE ET PROCÉDÉ DE FABRICATION D'UN COMPOSANT OPTOÉLECTRONIQUE

(30) Priorität: 31.01.2008 DE 102008006988
(43) Veröffentlichungstag der Anmeldung: 30.05.2018
(62) Teilanmeldung aus: 09706853.0
(73) Patentinhaber: OSRAM Opto Semiconductors GmbH, 93055 Regensburg (DE)
(72) Erfinder: Gmeinwieser, Nikolaus, 93093 Donaustauf (DE); Hahn, Berthold, 93155 Hemau (DE)
(74) Vertreter: Epping - Hermann - Fischer

(56) Entgegenhaltungen:
- DE-A1- 19 819 543

## Beschreibung

Die Erfindung betrifft ein optoelektronisches Bauelement und ein Verfahren zur Herstellung eines optoelektronischen Bauelements.

Um mit Hilfe von optoelektronischen Bauelementen weißes Licht zu erzeugen, werden die optoelektronischen Halbleiterbauelemente herkömmlicherweise mit einer Umhüllung versehen, die eine Konvertersubstanz enthält. Dieser Konvertersubstanz konvertiert die vom optoelektronischen Bauelement emittierte Strahlung eines ersten Wellenlängenbereichs (Primärstrahlung) in Strahlung eines zweiten Wellenlängenbereichs (Sekundärstrahlung), der sich von dem ersten Bereich unterscheidet. Weißes Licht kann auf diese Art entweder erzeugt werden, indem die Primärstrahlung mit der Sekundärstrahlung gemischt wird oder indem die Farbanteile der konvertierten Strahlung zusammengemischt weißes Licht ergeben.

Ein weiterer herkömmlicher Aufbau sieht vor, mehrere optoelektronische Bauelemente, die jeweils Strahlungen unterschiedlicher Wellenlängenbereiche emittieren, gemeinsam zu verwenden. Die Gesamtstrahlung des Aufbaus umfasst die addierten Wellenlängenbereiche der einzelnen Bauelemente.

Die DE19819543 A1 offenbart ein optoelektronisches Bauelement umfassend:
- einen ersten Halbleiterschichtenstapel, der eine zur Emission von Strahlung eingerichtete aktive Schicht und eine Hauptfläche aufweist,
- eine Trennschicht, die auf der Hauptfläche des ersten Halbleiterschichtenstapels angeordnet ist, wobei die Trennschicht einen halbdurchlässigen Spiegel bildet,
- einen zweiten Halbleiterschichtenstapel, der an der Trennschicht angeordnet ist und der eine weitere zur Emission von Strahlung eingerichtete aktive Schicht und eine Hauptfläche aufweist, weiterhin umfassend:

- ein Kontaktelement des zweiten Halbleiterschichtenstapels angeordnet auf der Hauptfläche des zweiten Halbleiterschichtenstapels,
- ein erstes Kontaktelement des ersten Halbleiterschichtenstapels angeordnet auf einer weiteren Hauptfläche des ersten Halbleiterschichtenstapels, wobei die weitere Hauptfläche der Hauptfläche gegenüber liegt,
- ein zweites Kontaktelement des ersten Halbleiterschichtenstapels angeordnet auf einer wiederum weiteren Hauptfläche des ersten Halbleiterschichtenstapels in einer Ausnehmung des ersten Halbleiterschichtenstapels, die durch die aktive Schicht des ersten Halbleiterschichtenstapels reicht, wobei die wiederum weitere Hauptfläche weniger weit als die Hauptfläche von der weiteren Hauptfläche beabstandet ist, wobei
- der erste Halbleiterschichtenstapel durch das erste Kontaktelement und das zweite Kontaktelement mit Spannung versorgt wird,
- der zweite Halbleiterschichtenstapel durch das zweite Kontaktelement und das Kontaktelement des zweiten Halbleiterschichtenstapels mit Spannung versorgt wird,
- die aktive Schicht des ersten Halbleiterschichtenstapels eingerichtet ist, Strahlung eines ersten Wellenlängenbereichs zu emittieren, und die aktive Schicht des zweiten Halbleiterschichtenstapels eingerichtet ist, Strahlung eines zweiten Wellenlängenbereichs zu emittieren,
- die Trennschicht für Strahlung des ersten Wellenlängenbereichs transparent ist und ausgebildet ist, Strahlung des zweiten Wellenlängenbereichs zu reflektieren, und - emittierte Strahlung des ersten Halbleiterschichtenstapels und emittierte Strahlung des zweiten Halbleiterschichtenstapels aus der Hauptfläche des ersten Halbleiterschichtenstapels austritt.

Es ist eine Aufgabe der Erfindung, ein optoelektronisches Bauelement sowie ein Verfahren zur Herstellung eines optoelektronischen Bauelements anzugeben, das sich einfacher und Platz sparender herstellen lässt und das effektiver ist.

Diese Aufgabe wird gelöst durch ein optoelektronisches Bauelement mit den Merkmalen des Anspruchs 1 beziehungsweise einem Verfahren mit den Merkmalen des Anspruchs 13.

Ein optoelektronisches Bauelement umfasst einen ersten Halbleiterschichtenstapel, der eine zur Emission von Strahlung eingerichtete Schicht und eine Hauptfläche aufweist. Auf dieser Hauptfläche ist eine Trennschicht angeordnet, die einen halbdurchlässigen Spiegel bildet. Das optoelektronische Bauelement umfasst einen zweiten Halbleiterschichtenstapel, der an der Trennschicht angeordnet ist und der eine weitere zur Emission von Strahlung eingerichtete aktive Schicht und eine Hauptfläche aufweist.

Die aktiven Schichten der beiden Halbleiterschichtenstapel sind erfindungsgemäß eingerichtet, Strahlung zweier unterschiedlicher Wellenlängenbereiche zu emittieren. Die Trennschicht ist für Strahlung eines ersten Wellenlängenbereichs transparent und ausgebildet Strahlung eines zweiten Wellenlängenbereichs zu reflektieren.

Die Trennschicht kann weiterhin aus mindestens zwei Schichten gebildet sein, wobei die Schichten mindestens zwei unterschiedliche Brechungsindizes aufweisen. Die Trennschicht kann ein elektrisch leitendes Material umfassen, die Trennschicht kann auch ein Dielektrikum umfassen. Die Trennschicht kann eine Strukturierung umfassen. Die Trennschicht kann außerdem mindestens eine Ausnehmung umfassen, in die ein elektrisch leitendes Material eingebracht ist.

Der erste und der zweite Halbleiterschichtenstapel des optoelektronischen Bauelements umfassen jeweils mindestens eine n- und eine p-dotierte Schicht. Das erste Kontaktelement kontaktiert eine dieser Schichten eines ersten Dotierungstyps und das zweite Kontaktelement eine weitere dieser Schichten eines zweiten Dotierungstyps.

An dem zweiten Halbleiterschichtenstapel ist ein drittes Kontaktelement angeordnet, das die aktive Schicht des zweiten Halbleiterschichtenstapels elektrisch kontaktiert. Dieses dritte Kontaktelement kann eine Schicht des ersten Dotierungstyps kontaktieren.

Die unterschiedlichen Halbleiterschichtenstapel des optoelektronischen Bauelements, insbesondere die jeweiligen zur Emission von Strahlung eingerichteten Schichten, können jeweils einzeln ansteuerbar sein. Insbesondere können die unterschiedlichen Halbleiterschichtenstapel des optoelektronischen Bauelements, insbesondere die jeweiligen zur Emission von Strahlung eingerichteten Schichten, jeweils einzeln elektrisch ansteuerbar sein. Das optoelektronische Bauelement kann Licht emittieren, das durch Kombination der jeweils aus den unterschiedlichen Halbleiterschichtenstapeln emittierten Strahlung erzeugt wird.

Das optoelektronische Bauelement kann weiterhin eine Konvertersubstanz zur teilweisen Wellenlängenkonversion von Strahlung umfassen. Die Konvertersubstanz kann an der Hauptfläche des zweiten Halbleiterschichtenstapels angeordnet sein. Das optoelektronische Bauelement kann Strahlung emittieren, die durch Kombination der aus den unterschiedlichen Halbleiterschichtenstapeln emittierten Strahlung und der Strahlung der Konvertersubstanz erzeugt wird.

Ein Verfahren zum Herstellen eines optoelektronischen Bauelements umfasst ein Bereitstellen eines ersten Substrats, ein Erzeugen eines ersten Halbleiterschichtenstapels mit einer zur Emission von Strahlung eingerichteten aktiven Schicht auf dem ersten Substrat und ein Ablösen des Substrats von dem Halbleiterschichtenstapel.

Ein zweites Substrat wird bereitgestellt, auf dem ein zweiter Halbleiterschichtenstapel mit einer zur Emission von Strahlung geeigneten aktiven Schicht erzeugt wird. Das zweite Substrat wird von dem zweiten Halbleiterschichtenstapel abgelöst.

Das Verfahren umfasst weiterhin ein Aufbringen einer Trennschicht, die einen halbdurchlässigen Spiegel bildet, auf mindestens einem der Halbleiterschichtenstapel und ein Aufbringen des zweiten Halbleiterschichtenstapels auf den ersten Halbleiterschichtenstapel, so dass die Trennschicht zwischen dem ersten und dem zweiten Halbleiterschichtenstapel angeordnet ist.

Auf einer Hauptfläche des zweiten Halbleiterschichtenstapels gegenüberliegenden weiteren Hauptfläche des zweiten Halbleiterschichtstapels kann ein erster Hilfsträger aufgebracht werden. Ein zweiter Hilfsträger kann auf der Hauptfläche des zweiten Halbleiterschichtenstapels aufgebracht werden. Der erste Hilfsträger und der zweite Hilfsträger können wieder abgelöst werden. Auf einer Hauptfläche des ersten Halbleiterschichtenstapels kann ein weiterer Hilfsträger aufgebracht und wieder abgelöst werden.

Das Erzeugen der Halbleiterschichtenstapel kann jeweils ein epitaktisches Abscheiden von mindestens zwei unterschiedlich dotierten Halbleiterschichten sowie jeweils ein Strukturieren der dotierten Halbleiterschichten zu ihren elektrischen Kontaktierungen umfassen.

In dem ersten Halbleiterschichtenstapel wird mindestens eine Ausnehmung ausgebildet, die durch eine Schicht eines ersten Dotierungstyps und durch die aktive Schicht mindestens bis zu einer Schicht eines zweiten Dotierungstyps reicht.

In dem zweiten Halbleiterschichtenstapel kann mindestens eine Ausnehmung ausgebildet werden, die durch eine Schicht eines ersten Dotierungstyps und durch die aktive Schicht mindestens bis zu einer Schicht eines zweiten Dotierungstyps reicht.

Die Trennschicht kann aus mindestens zwei Schichten gebildet werden, wobei die mindestens zwei Schichten mindestens zwei unterschiedliche Brechungsindizes aufweisen. Die Trennschicht kann eine Strukturierung aufweisen. Die Trennschicht kann mit mindestens einer Ausnehmung ausgebildet werden, und diese Ausnehmung mit einem elektrisch leitenden Material gefüllt werden.

Auf die Hauptfläche des zweiten Halbleiterschichtenstapels kann eine Konvertersubstanz zur teilweisen Wellenlängenkonversion der emittierbaren Strahlung aufgebracht werden.

Weitere Merkmale, Vorteile und Weiterbildungen ergeben sich aus den nachfolgenden in Verbindung mit den Figuren 1 bis 5 erläuternden Beispielen.

Es zeigen:
- Figur 1: eine schematische Darstellung eines optoelektronischen Bauelements gemäß einer Ausführungsform,
- Figur 2: eine weitere schematische Darstellung eines optoelektronischen Bauelements,
- Figuren 3A und 3B: eine schematische Aufsicht auf ein Ausführungsbeispiel eines optoelektronischen Bauelements beziehungsweise eine schematische Sicht auf die Unterseite eines optoelektronischen Bauelements,
- Figuren 4A und 4B: eine schematische Aufsicht auf ein weiteres Ausführungsbeispiel eines optoelektronischen Bauelements beziehungsweise eine Aufsicht auf eine Unterseite eines optoelektronischen Bauelements,
- Figuren 5A bis 5H: schematische Schnittansichten eines Halbleiterschichtenstapels während verschiedener Verfahrensstadien.

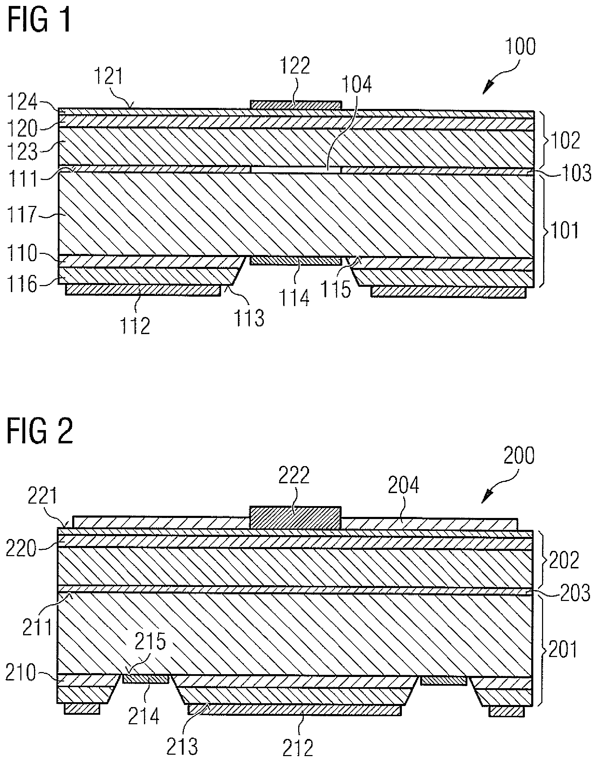

Figur 1 zeigt ein optoelektronisches Bauelement 100, dass einen ersten Halbleiterschichtenstapel 101 und einen zweiten Halbleiterschichtenstapel 102 hat. Die Figur 1 zeigt weiterhin eine Trennschicht 103, mit einer Ausnehmung 104, eine aktive Schicht 110, eine erste Hauptfläche 111, ein erstes Kontaktelement 112, eine weitere Hauptfläche 113, ein weiteres Kontaktelement 114, eine weitere Hauptfläche 115, eine zweite aktive Schicht 120, eine Hauptfläche den zweiten Halbleiterschichtenstapel 121, sowie ein weiteres Kontaktelement 122.

Der Halbleiterschichtenstapel 101 umfasst in der gezeigten Figur drei Schichten. Eine erste Schicht (116) weist einen ersten Dotierungstyp, beispielsweise p-dotiert, und eine Hauptfläche 113 auf. Gegenüber der Fläche 113 grenzt an die erste Schicht die aktive Schicht 110 an. An der aktiven Schicht grenzt eine weitere Halbleiterschicht (117) an, die beispielsweise n-dotiert ist. Die aktive Schicht weist einen Strahlung erzeugenden pn-Übergang auf, der mittels der p-dotierten und der n-dotierten Schicht gebildet ist, die an der aktiven Schicht angrenzen.

Auf der Hauptfläche 111 kann die Trennschicht 103 angeordnet sein. Die Trennschicht kann wie im gezeigten Ausführungsbeispiel die Ausnehmung 104 umgeben. Auf der Trennschicht kann der zweite Halbleiterschichtenstapel, der ebenfalls beispielsweise drei Schichten umfassen kann, angeordnet sein.

Die an die Trennschicht angrenzende Schicht (123) ist beispielsweise eine n-dotierte Schicht. Darauf können eine aktive Schicht und eine p-dotierte Schicht (124) folgen. Die aktive Schicht weist wiederum einen Strahlung erzeugenden pn-Übergang auf. Sowohl der erste als auch der zweite Halbleiterschichtenstapel können auch mehr als drei Schichten, beispielsweise eine zusätzliche Pufferschicht, aufweisen. Die Schichten die jeweils von dem ersten und dem zweiten Halbleiterschichtstapel an der Trennschicht angrenzen können den gleichen Dotierungstyp aufweisen.

Die Trennschicht kann aus mehreren Schichten gebildet sein. Die Trennschicht weist mindestens zwei Schichten auf, die sich durch Material oder Schichtdicke voneinander unterscheiden können. Die Schichten der Trennschicht können jeweils unterschiedliche Brechungsindizes aufweisen. Die Brechungsindizes der Schichten wiederholen sich beispielsweise in regelmäßigen Abständen. Die Trennschicht ist beispielsweise ein Dielektrikum. Sie kann aus Siliziumoxid, aus Zinkoxid oder Indumzinkoxid gebildet sein, sie kann aber auch ein anderes Material umfassen. Die Trennschicht kann eine Strukturierung, beispielsweise eine Mikrostrukturierung, insbesondere eine Nanostrukturierung, insbesondere mindestens einen photonischen Kristall umfassen, der an dem ersten, an dem zweiten, oder an beiden Halbleiterschichtenstapeln ausgebildet ist.

Das Kontaktelement 112 ist an der Hauptfläche 113 der beispielsweise p-dotierten Schicht des ersten Halbleiterschichtenstapels angeordnet. Das Kontaktelement kann aus einer Kontaktfläche, es kann aber auch aus mehreren Kontaktflächen gebildet sein.

In der gezeigten Ausführungsform ist die Hauptfläche 121 am weitesten von der Hauptfläche 113 beabstandet. Die Hauptfläche 111 ist weniger weit als die Hauptfläche 121 von der Hauptfläche 113 beabstandet. Die Hauptfläche 115 ist weniger weit als die Hauptfläche 111 von der Hauptfläche 113 beabstandet.

Der Halbleiterschichtenstapel 101 weist zur Kontaktierung der beispielsweise n-dotierten Schicht eine Ausnehmung auf, die durch den p-dotierten Bereich und die aktive Schicht reicht. Die n-dotierte Schicht weist in dieser Ausführungsform beispielsweise eine Hauptfläche 115 auf, an die ein zweites Kontaktelement 114 aufgebracht sein kann. Der Halbleiterstapel kann eine derartige Ausnehmung aufweisen, er kann aber auch mehrere solcher Ausnehmungen haben.

Die Kontaktelemente sind beispielsweise aus einem elektrisch leitenden Material gebildet. Über die Kontaktelemente kann der Halbleiterschichtenstapel 101 mit einer Spannung versorgt werden, wenn das optoelektronische Bauelement auf einem entsprechenden Trägerelement montiert ist. Die von dem Halbleiterschichtenstapel, insbesondere der aktiven Schicht 110 bei angelegter Spannung emittierte Strahlung tritt hauptsächlich aus der Fläche 111 aus.

Zum Anlegen einer Spannung an den zweiten Halbleiterschichtenstapel 102 ist auf der Fläche 121 das Kontaktelement 122 angebracht. Das Kontaktelement kann aus einer Kontaktfläche, es kann aber auch aus mehreren Kontaktflächen gebildet sein. Das Kontaktelement 122 kontaktiert die beispielsweise p-dotierte Schicht. Die beispielsweise n-dotierte Schicht des Schichtenstapels 102 wird über das Kontaktelement 114, beziehungsweise über die Trennschicht oder durch ein leitendes Material in der Ausnehmung 104 der Trennschicht kontaktiert. Der Halbleiterschichtenstapel 102 wird also durch die Kontaktelemente 114 und 122 mit Spannung versorgt. Die Kontaktelemente können lichtdurchlässige Leiter, die beispielsweise Indiumzinkoxid umfassen, aufweisen.

Die Kontaktelemente können in einer nicht beanspruchten Ausführungsform aus Richtung der Fläche 121 die aktiven Schichten kontaktieren. Es kann mindestens eine Ausnehmung durch die Schicht 124 und die Schicht 120 gebildet sein. Es kann mindestens eine Ausnehmung durch die Schicht 124, die Schicht 120, die Schicht 123 und die Trennschicht gebildet sein. Es kann mindestens eine Ausnehmung durch die Schicht 124, die Schicht 120, die Schicht 123, die Trennschicht, die Schicht 117 und die aktive Schicht 110 gebildet sein. Es kann mindestens eine weitere Ausnehmung durch andere Schichten gebildet sein. In den Ausnehmung kann jeweils mindestens ein Kontaktelement angeordnet sein.

Die Halbleiterschichtenstapel emittieren jeweils Strahlung unterschiedlicher Wellenlängenbereiche. Der Halbleiterschichtenstapel 101 emittiert beispielsweise Strahlung mit längeren Wellenlängen als der Halbleiterschichtenstapel 102. Beispielsweise emittiert der erste Halbleiterschichtenstapel 101 Strahlung im roten Farbbereich (625 bis 740 nm), der Halbleiterschichtenstapel 102 Strahlung im blauen Farbbereich (400 bis 500 nm).

Die Trennschicht ist für den Wellenlängenbereich der emittierten Strahlung des Halbleiterschichtenstapels 101 möglichst transparent. Für die emittierte Strahlung des Halbleiterschichtenstapels 102 ist die Trennschicht möglichst undurchlässig und reflektiert einen möglichst großen Anteil dieser Strahlung. Eine Reabsorption der Strahlung des Halbleiterschichtenstapels 102 im Halbleiterschichtenstapel 101 kann so weitestgehend verhindert werden. Sowohl die emittierte Strahlung des Halbleiterschichtenstapels 101 als auch die emittierte Strahlung des Halbleiterschichtenstapels 102 treten im Wesentlichen aus der Fläche 121 aus. Die Spektralbereiche der jeweiligen emittierten Strahlung addieren sich zu einem Gesamtspektrum.

Durch ein Anlegen unterschiedlicher Spannungen an die jeweiligen Halbleiterschichtenstapel können die unterschiedlichen Wellenlängenbereiche verschieden stark an dem Gesamtspektrum beteiligt werden. So ist während des Betriebs des optoelektronischen Bauelements ein Einstellen eines gewünschten Farborts möglich.

Figur 2 zeigt ein optoelektronisches Bauelement 200 mit einem Halbleiterschichtenstapel 201 und einem weiteren Halbleiterschichtenstapel 202. Figur 2 zeigt weiterhin eine Trennschicht 203, eine Konvertersubstanz 204, eine erste aktive Schicht 210, eine Hauptfläche 211, ein erstes Kontaktelement 212, eine zweite Hauptfläche 213, ein zweites Kontaktelement 214, eine weitere Hauptfläche 215, eine aktive Schicht 220, eine weitere Hauptfläche 221, und ein Kontaktelement 221.

Der Halbleiterschichtenstapel 201 weist mindestens drei Schichten auf, beispielsweise eine p-dotierte Schicht, eine aktive Schicht und eine n-dotierte Schicht. Er weist weiterhin Ausnehmungen auf, die bis zu der beispielsweise n-dotierten Schicht reichen. Auf der n-dotierten Schicht gegenüber einer Hauptfläche 213, die an der beispielsweise p-dotierten Schicht angeordnet ist, ist die Trennschicht angeordnet. Im gezeigten Ausführungsbeispiel ist die Trennschicht elektrisch leitfähig.

Auf der Trennschicht ist der zweite Halbleiterschichtenstapel 202 angeordnet, der ebenfalls beispielsweise drei Schichten umfasst. Eine n-dotierte Schicht ist benachbart zur Trennschicht angeordnet. Benachbart zur n-dotierten Schicht ist die aktive Schicht angeordnet und benachbart zur aktiven Schicht eine p-dotierte Schicht. Die p-dotierte Schicht weist die Hauptfläche 221 auf. Auf dieser Hauptfläche 221 kann die Konvertersubstanz angeordnet sein.

Die Konvertersubstanz kann, wenn sie durch elektromagnetische Strahlung eines bestimmten Wellenlängenbereichs angeregt wird, Strahlung eines anderen Wellenlängenbereichs emittieren. Dazu kann es mindestens einen Leuchtstoff enthalten. Der Leuchtstoff kann anorganische oder organische Leuchtstoffe enthalten.

Die Wellenlängenbereiche der anregenden und der emittierten Strahlung der Konvertersubstanz können sich unterscheiden.

Die Konvertersubstanz kann entweder die gesamte auf sie eintreffende Strahlung umwandeln, sie kann auch nur einen Teil der eintreffenden Strahlung konvertieren und den übrigen Teil durchlassen, ohne den Wellenlängenbereich der durchgelassenen Strahlung signifikant zu beeinflussen.

In den Ausnehmungen des Halbleiterschichtenstapels 201 ist auf einer Hauptfläche 215 das Kontaktelement 214 angeordnet. Auf der Hauptfläche 213 kann das weitere Kontaktelement 212 angeordnet sein. Über die Kontaktelemente kann der Halbleiterschichtenstapel mit einer Spannung versorgt werden und so Strahlung emittieren. Die Strahlung wird von der Trennschicht 203 transmittiert. Die Strahlung koppelt in den zweite Halbleiterschichtenstapel 202 ein.

Die Anordnung der Kontaktelemente ist frei wählbar. Der Halbleiterschichtenstapel kann zur p-seitigen Kontaktierung und zur n-seitigen Kontaktierung von seiner Vorderseite her, zur p-seitigen und n-seitigen Kontaktierung von seiner Rückseite her, zur p-seitigen Kontaktierung von seiner Vorderseite her und zur n-seitigen Kontaktierung von seiner Rückseite, zur n-seitigen Kontaktierung von seiner Vorderseite her und zur p-seitigen Kontaktierung von seiner Rückseite, sowie zur n- und/oder p-seitigen Kontaktierung sowohl von der Vorder- wie von der Rückseite her ausgebildet sein.

Der Halbleiterschichtenstapel 202 kann über das Kontaktelement 222 das auf der Hauptfläche 221 angeordnet ist und über das Kontaktelement 214 und somit auch über die Trennschicht 203 mit Spannung versorgt werden. Die Trennschicht umfasst in dieser Ausführungsform elektrisch leitfähiges Material. Wirkt die Trennschicht elektrisch isolierend, umfasst sie mindestens eine Ausnehmung, die mit einem elektrisch leitfähigem Material gefüllt ist, wie in Figur 1 gezeigt. Der Halbleiterschichtenstapel 202 kann so Strahlung emittieren, wenn eine Spannung angelegt ist. Die Strahlung in einem von der aktiven Schicht des Halbleiterschichtenstapels 202 emittierten Wellenlängenbereichs wird von der Trennschicht 203 möglichst gut reflektiert.

Die emittierte Strahlung des ersten Halbleiterschichtenstapels liegt in einem anderen Wellenlängenbereich als die emittierte Strahlung des zweiten Halbleiterschichtenstapels. Die Konvertersubstanz konvertiert einen Teil der Strahlung, die im Wellenlängenbereich des zweiten Halbleiterschichtenstapels liegt. Die Konvertersubstanz kann Strahlung, die im Wellenlängenbereich des ersten Halbleiterschichtenstapels liegt, transmittieren. Das Gesamtspektrum der emittierten Strahlung des Halbleiterbauelements kann so beispielsweise aus mindestens drei unterschiedlichen Wellenlängenbereichen zusammengesetzt sein.

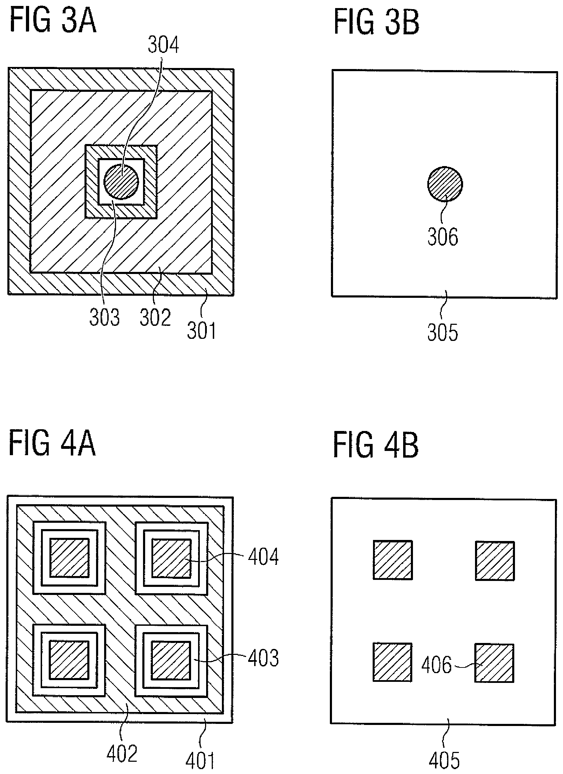

Figur 3A und 3B zeigen eine Hauptfläche 301, ein Kontaktelement 302, eine weitere Hauptfläche 303, ein weiteres Kontaktelement 304, eine weitere Hauptfläche 305 und ein weiteres Kontaktelement 306.

Figur 3A zeigt eine Sicht auf die Unterseite eines beispielsweise in Figur 1 gezeigten optoelektronischen Bauelement. Die Fläche 301 ist die Fläche einer beispielsweise p-dotierten Halbleiterschicht. Auf dieser Fläche ist das Kontaktelement 302 aufgebracht. Das Kontaktelement kann wie in der gezeigten Ausführungsform ein zusammenhängendes Element sein. Es kann aber auch aus mehreren einzelnen Bereichen gebildet sein. Das Bauelement weist, beispielsweise mittig, eine Ausnehmung auf, die durch die beispielsweise p-dotierte Schicht und eine aktive Schicht bis zu einer beispielsweise n-dotierten Schicht reicht. Diese beispielsweise n-dotierte Schicht weist die Hauptfläche 303 auf. Auf dieser Hauptfläche ist ein weiteres Kontaktelement 304 aufgebracht. Die Kontaktelemente 302 und 304 dienen dazu das Halbleiterbauelement mit Spannung versorgen zu können. Die Dotierungstypen der Schichten kann auch anders als in dieser Ausführungsform sein, beispielsweise kann die p-dotierte Schicht eine n-dotierte Schicht sein und umgekehrt. Die Unterseite des optoelektronischen Bauelements kann weitere Elemente, beispielsweise Metallisierungen oder Trägersubstrat, aufweisen.

Die Figur 3B zeigt eine Oberfläche eines Figur 3A entsprechenden optoelektronischen Bauelements. Dieses hat die Hauptfläche 305, auf die das Kontaktelement 306 aufgebracht ist. Das Kontaktelement 306 ist beispielsweise direkt über dem Kontaktelement 305 aufgebracht.

Durch die Anordnung des Kontaktelements 306 direkt oberhalb des Kontaktelements 305 hat das Bauelement insgesamt möglichst wenig Bereiche, aus denen keine Strahlung emittiert wird. Das Kontaktelement 306 kann aber auch an einer anderen Stelle der Hauptfläche 305 angeordnet sein, beispielsweise in einem Randbereich. Es können auch mehrere Kontaktelemente angeordnet sein. Insbesondere können sich die Anzahlen der Kontaktelemente 305 und 306 unterscheiden. Es kann ein transparentes, leitfähiges Material zwischen dem Kontaktelement und der Hauptfläche aufgebracht sein, um die Kontaktierung zu verbessern.

Figuren 4A und 4B zeigen eine Hauptfläche 401, ein erstes Kontaktelement 402, eine Hauptfläche 403, ein zweites Kontaktelement 404, eine weitere Hauptfläche 405, ein weiteres Kontaktelement 406.

Figur 4A zeigt die in Figur 3A gezeigte Struktur vier mal an einem Bauelement ausgebildet. Auf die Hauptfläche 401 kann das Kontaktelement 402 aufgebracht sein. Das Kontaktelement kann aus mehreren Einzelteilen gebildet sein. Die Ausnehmungen, die eine Kontaktierung der Fläche 403 ermöglichen, können beliebig oft wiederholt werden. Im gezeigten Ausführungsbeispiel sind vier Ausnehmungen mit Kontaktelementen 404 symmetrisch angeordnet, die Ausnehmungen können aber auch anders angeordnet sein.

Figur 4B zeigt eine entsprechende Aufsicht auf ein Bauelement. Die Kontaktelemente 406 können auf der Hauptfläche 405 oberhalb der Kontaktelemente 404 angeordnet sein. Sie können dabei genauso viele Einzelteilen wie das Kontaktelement 404 umfassen, es können aber auch weniger oder mehr Einzelteile vorhanden sein. Die Einzelteile des Kontaktelements 406 können wie gezeigt direkt oberhalb der Elemente 404 angeordnet sein, sie können aber auch beliebig anders auf der Kontaktfläche 405 angeordnet sein.

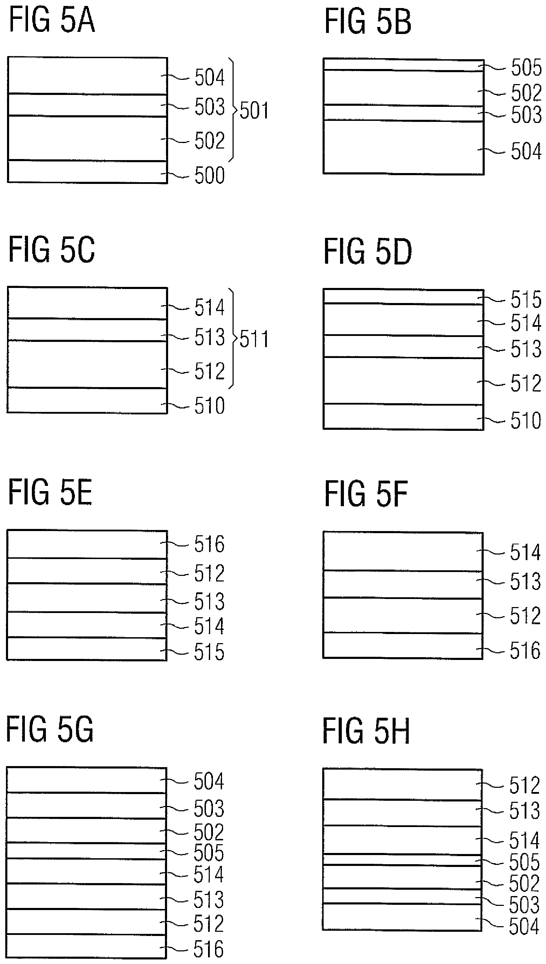

Figur 5A zeigt einen Ausschnitt aus einem Substratwafer 500, einen Halbleiterschichtenstapel 501, der eine dotierte Schicht 502, eine aktive Schicht 503 und eine weitere dotierte Schicht 504 umfasst.

Der Substratwafer ist beispielsweise aus Galliumarsenid gebildet. Der Halbleiterschichtenstapel kann weitere Schichten enthalten. Der Substratwafer kann auch aus einem anderen geeigneten Material gebildet sein. In einen Verfahren können mehrere Halbleiterschichtenstapel auf einem Substratwafer gebildet werden, die in einem späteren Verfahrensschritt vereinzelt werden.

In einem Verfahrensschritt werden die Schichten des Halbleiterschichtenstapels 501 auf dem Substrat aufgewachsen. Der Halbleiterschichtenstapel wird dabei beispielsweise mit einer n-dotierten Schicht beginnend auf dem Substrat aufgewachsen. Nachfolgend wird beispielsweise die aktive Schicht und eine p-dotierte Schicht aufgewachsen. Anschließend kann das Substrat von dem Halbleiterschichtenstapel entfernt werden. Vor dem Entfernen des Substrats kann ein Hilfsträger auf den Halbleiterschichtenstapel aufgebracht werden.

Figur 5B zeigt den Halbleiterschichtenstapel aus Figur 5A ohne den Substratwafer. Auf die Schicht 502 ist eine Trennschicht 505 aufgebracht worden. Diese Trennschicht ist beispielsweise aus mehreren Schichen gebildet worden. Die Trennschicht bildet einen Spiegel, der halbdurchlässig ist. Die Trennschicht ist beispielsweise für bestimmte Wellenlängenbereiche möglichst transparent und reflektiert andere Wellenlängenbereiche.

Figur 5C zeigt einen weiteren Substratwafer 510, einen weiteren Halbleiterschichtenstapel 511, der eine erste dotierte Schicht 512, eine aktive Schicht 513 und eine weitere dotierte Schicht 514 umfasst. Der Schichtenstapel wird auf dem Substratwafer, der beispielsweise Saphir umfasst, aufgewachsen. Er kann auch mehr als 3 Schichten umfassen. Beispielsweise wird der Halbleiterschichtenstapel mit einer n-dotierten Schicht beginnend aufgewachsen. Auf dem Substratwafer 510 können mehrere Halbleiterschichtenstapel gebildet werden, die in einem späteren Verfahrensschritt vereinzelt werden.

Die Trennschicht 505 kann auch auf dem Schichtenstapel 511 aufgebracht werden. Sie kann auch auf einem der Schichtenstapel aufgebracht werden, sie kann aber auch auf beide Schichtenstapel aufgebracht werden.

Figur 5D zeigt einen Verfahrensschritt eines Ausführungsbeispiels, in dem ein Hilfsträger 515 auf dem zweiten Halbleiterschichtenstapel, insbesondere auf der Schicht 514 aufgebracht wird.

Wie in Figur 5E gezeigt, kann ein zweiter Hilfsträger 516 auf den Halbleiterschichtenstapel 511, insbesondere auf die Schicht 512, aufgebracht werden und das Substrat 510 von dem Halbleiterschichtenstapel abgelöst werden.

Die Figur 5F ist der Verfahrensschritt des Ablösens des ersten Hilfsträgers 515 bereits vollzogen. Die in Figur 5B und in Figur 5F gezeigten Elemente können kombiniert werden.

Figur 5G zeigt das Element aus Figur 5B, das auf die Schicht 514 aufgebracht wurde, so dass die Trennschicht 505 zwischen den beiden Schichtenstapeln angeordnet ist.

Figur 5H zeigt die Schichtenstapel, nachdem der zweite Hilfsträger 516 von der Schicht 512 abgelöst wurde. Der gezeigte Schichtenstapel entspricht nun im Wesentlichen dem eines Bauelements wie in Figur 1 gezeigt.

Das Verfahren kann weitere Verfahrensschritte, beispielsweise ein Aufbringen eines Konvertersubstrats auf die Schicht 512, oder ein Ausbilden von Kontaktelementen auf den Halbleiterschichten beinhalten. Das Verfahren kann weiterhin ein Ausbilden einer Ausnehmung der Trennschicht und ein Füllen der Trennschicht mit einem leitenden Material umfassen. Insbesondere muss das Verfahren nicht alle oben genannten Verfahrensschritte umfassen. Beispielsweise kann der erste Halbleiterschichtenstapel auf den zweiten Halbleiterschichtenstapel aufgebracht werden, bevor das Substrat entfernt wird. Die Herstellung der Halbleiterschichtenstapel kann jeweils keinen, einen oder zwei Hilfsträger aufweisen.

## Patentansprüche

1. Optoelektronisches Bauelement (100) umfassend:
- einen ersten Halbleiterschichtenstapel (101), der eine zur Emission von Strahlung eingerichtete aktive Schicht (110) und eine Hauptfläche (111) aufweist,
- eine Trennschicht (103), die auf der Hauptfläche (111) des ersten Halbleiterschichtenstapels angeordnet ist, wobei die Trennschicht einen halbdurchlässigen Spiegel bildet,
- einen zweiten Halbleiterschichtenstapel (102), der an der Trennschicht (103) angeordnet ist und der eine weitere zur Emission von Strahlung eingerichtete aktive Schicht (120) und eine Hauptfläche (121) aufweist,
weiterhin umfassend:
- ein Kontaktelement (122) des zweiten Halbleiterschichtenstapels (102) angeordnet auf der Hauptfläche (121) des zweiten Halbleiterschichtenstapels (102),
- ein erstes Kontaktelement (112) des ersten Halbleiterschichtenstapels angeordnet auf einer weiteren Hauptfläche (113) des ersten Halbleiterschichtenstapels, wobei die weitere Hauptfläche (113) der Hauptfläche (111) gegenüber liegt,
- ein zweites Kontaktelement (114) des ersten Halbleiterschichtenstapels angeordnet auf einer wiederum weiteren Hauptfläche (115) des ersten Halbleiterschichtenstapels in einer Ausnehmung des ersten Halbleiterschichtenstapels, die durch die aktive Schicht des ersten Halbleiterschichtenstapels reicht, wobei die wiederum weitere Hauptfläche (115) weniger weit als die weitere Hauptfläche (113) von der Hauptfläche (111) beabstandet ist, wobei
- der erste Halbleiterschichtenstapel (101) durch das erste Kontaktelement (112) und das zweite Kontaktelement (114) mit Spannung versorgt wird,
- der zweite Halbleiterschichtenstapel (102) durch das zweite Kontaktelement (114) und das Kontaktelement (122) des zweiten Halbleiterschichtenstapels (102) mit Spannung versorgt wird,
- die aktive Schicht (110) des ersten Halbleiterschichtenstapels eingerichtet ist, Strahlung eines ersten Wellenlängenbereichs zu emittieren, und die aktive Schicht (120) des zweiten Halbleiterschichtenstapels eingerichtet ist, Strahlung eines zweiten Wellenlängenbereichs zu emittieren,
- die Trennschicht (103) für Strahlung des ersten Wellenlängenbereichs transparent ist und ausgebildet ist, Strahlung des zweiten Wellenlängenbereichs zu reflektieren, **dadurch gekennzeichnet, dass**
- emittierte Strahlung des ersten Halbleiterschichtenstapels (101) und emittierte Strahlung des zweiten Halbleiterschichtenstapels (102) aus der Hauptfläche (121) des zweiten Halbleiterschichtenstapels (102) austritt.

2. Optoelektronisches Bauelement nach Anspruch 1, wobei die Trennschicht (103) mindestens zwei Schichten umfasst, wobei die Schichten mindestens zwei unterschiedliche Brechungsindizes aufweisen.

3. Optoelektronisches Bauelement nach einem der Ansprüche 1 bis 2, wobei die Trennschicht (103) ein elektrisch leitendes Material umfasst.

4. Optoelektronisches Bauelement nach einem der Ansprüche 1 bis 2, wobei die Trennschicht (103) ein Dielektrikum umfasst.

5. Optoelektronisches Bauelement nach einem der Ansprüche 1 bis 4, wobei die Trennschicht (103) eine Strukturierung aufweist.

6. Optoelektronisches Bauelement nach Anspruch 4 oder 5, wobei die Trennschicht (103) mindestens eine Ausnehmung (104) umfasst, in die ein elektrisch leitendes Material eingebracht ist.

7. Optoelektronisches Bauelement nach einem der Ansprüche 1 bis 6, wobei die unterschiedlichen Halbleiterschichtenstapel (101, 102) jeweils einzeln ansteuerbar sind.

8. Optoelektronisches Bauelement nach einem der Ansprüche 1 bis 7, weiterhin umfassend: eine Konvertersubstanz (204) zur teilweisen Wellenlängenkonversion von Strahlung, wobei die Konvertersubstanz an der Hauptfläche (121, 221) des zweiten Halbleiterschichtenstapels angeordnet ist.

9. Verfahren zum Herstellen eines optoelektronischen Bauelements, umfassend:
- Bereitstellen eines ersten Substrats (500),
- Erzeugen eines ersten Halbleiterschichtenstapels (501) mit einer zur Emission von Strahlung eingerichteten aktiven Schicht (503) auf dem ersten Substrat,
- Ablösen des Substrats (500) von dem ersten Halbleiterschichtenstapel,
- Bereitstellen eines zweiten Substrats (510),
- Erzeugen eines zweiten Halbleiterschichtenstapels (511) mit einer zur Emission von Strahlung geeigneten aktiven Schicht (513) auf dem zweiten Substrat und einer Hauptfläche (121),
- Ablösen des zweiten Substrats (510) von dem zweiten Halbleiterschichtenstapel,
- Aufbringen einer Trennschicht (505), die einen halbdurchlässigen Spiegel bildet, auf mindestens einem der Halbleiterschichtenstapel,
- Aufbringen des zweiten Halbleiterschichtenstapels (511) auf den ersten Halbleiterschichtenstapel (501), so dass die Trennschicht (505) zwischen dem erstem und dem zweitem Halbleiterschichtenstapel angeordnet ist,
- Ausbilden einer Ausnehmung im ersten Halbleiterschichtenstapel, die durch die aktive Schicht reicht,
- Ausbilden eines ersten Kontaktelements (112) und eines zweiten Kontaktelements (114) des ersten Halbleiterschichtenstapels (101), wobei das zweite Kontaktelement (112) in der Ausnehmung angeordnet ist, und
- Ausbilden eines Kontaktelements (122) des zweiten Halbleiterschichtenstapels (102) auf der Hauptfläche (121) des zweiten Halbleiterschichtenstapels (102),
wobei
- der erste Halbleiterschichtenstapel (101) durch das erste Kontaktelement (112) und das zweite Kontaktelement (114) mit Spannung versorgt wird,
- der zweite Halbleiterschichtenstapel (102) durch das zweite Kontaktelement (114) und das Kontaktelement (122) des zweiten Halbleiterschichtenstapels (102) mit Spannung versorgt wird,
- die aktive Schicht (110) des ersten Halbleiterschichtenstapels eingerichtet ist, Strahlung eines ersten Wellenlängenbereichs zu emittieren, und die aktive Schicht (120) des zweiten Halbleiterschichtenstapels eingerichtet ist, Strahlung eines zweiten Wellenlängenbereichs zu emittieren,
- die Trennschicht (103) für Strahlung des ersten Wellenlängenbereichs transparent ist und ausgebildet ist, Strahlung des zweiten Wellenlängenbereichs zu reflektieren, und
- emittierte Strahlung des ersten Halbleiterschichtenstapels (101) und emittierte Strahlung des zweiten Halbleiterschichtenstapels (102) aus der Hauptfläche (121) des zweiten Halbleiterschichtenstapels (102) austritt.

10. Verfahren nach Anspruch 9, umfassend:
- Ausbilden mindestens einer Ausnehmung (104) der Trennschicht (103),
- Füllen der Ausnehmung (104) der Trennschicht (103) mit einem elektrisch leitenden Material.

## Claims

1. Optoelectronic device (100) comprising:
- a first semiconductor layer stack (101), which has an active layer (110) configured to emit radiation and a main surface (111),
- a separation layer (103) arranged on the main surface (111) of the first semiconductor layer stack, wherein the separation layer forms a semi-transparent mirror,
- a second semiconductor layer stack (102), which is arranged at the separation layer (103) and which has a further active layer (120) configured to emit radiation and a main surface (121),
further comprising:
- a contact element (122) of the second semiconductor layer stack (102) arranged on the main surface (121) of the second semiconductor layer stack (102),
- a first contact element (112) of the first semiconductor layer stack arranged on a further main surface (113) of the first semiconductor layer stack, wherein the further main surface (113) is opposite to the main surface (111),
- a second contact element (114) of the first semiconductor layer stack arranged on a again further main surface (115) of the first semiconductor layer stack in a recess of the first semiconductor layer stack extending through the active layer of the first semiconductor layer stack, wherein the again further main surface (115) is spaced apart less far than the further main surface (113) from the main surface (111), wherein
- the first semiconductor layer stack (101) is supplied with voltage by the first contact element (112) and the second contact element (114),
- the second semiconductor layer stack (102) is supplied with voltage by the second contact element (114) and the contact element (122) of the second semiconductor layer stack (102),
- the active layer (110) of the first semiconductor layer stack is configured to emit radiation of a first wavelength range, and the active layer (120) of the second semiconductor layer stack is configured to emit radiation of a second wavelength range,
- the separating layer (103) is transparent to radiation of the first wavelength range and is configured to reflect radiation of the second wavelength range, **characterized in that**
- emitted radiation of the first semiconductor layer stack (101) and emitted radiation of the second semiconductor layer stack (102) emerges from the main surface (121) of the second semiconductor layer stack (102).

2. Optoelectronic device according to claim 1, wherein the separation layer (103) comprises at least two layers, wherein the layers have at least two different refractive indices.

3. Optoelectronic device of any one of claims 1 to 2, wherein the separation layer (103) comprises an electrically conductive material.

4. Optoelectronic device according to any one of claims 1 to 2, wherein the separation layer (103) comprises a dielectric.

5. Optoelectronic device according to any one of claims 1 to 4, wherein the separation layer (103) comprises a patterning.

6. Optoelectronic device according to claim 4 or 5, wherein the separation layer (103) comprises at least one recess (104) into which an electrically conductive material is introduced.

7. Optoelectronic device according to any one of claims 1 to 6, wherein the different semiconductor layer stacks (101, 102) are each individually drivable.

8. Optoelectronic device according to any one of claims 1 to 7, further comprising: a converter substance (204) for partial wavelength conversion of radiation, wherein the converter substance is arranged on the main surface (121, 221) of the second semiconductor layer stack.

9. Method of producing an optoelectronic device, comprising:
- providing a first substrate (500),
- generating a first semiconductor layer stack (501) having an active layer (503) configured to emit radiation on the first substrate,
- detaching the substrate (500) from the first semiconductor layer stack,
- providing a second substrate (510),
- generating a second semiconductor layer stack (511) having an active layer (513) suitable for emitting radiation on the second substrate and a main surface (121),
- detaching the second substrate (510) from the second semiconductor layer stack,
- depositing a separation layer (505) forming a semi-transparent mirror on at least one of the semiconductor layer stacks,
- depositing the second semiconductor layer stack (511) on the first semiconductor layer stack (501) so that the separation layer (505) is arranged between the first and second semiconductor layer stacks,
- forming a recess in the first semiconductor layer stack that extends through the active layer,
- forming a first contact element (112) and a second contact element (114) of the first semiconductor layer stack (101), wherein the second contact element (112) is arranged in the recess, and
- forming a contact element (122) of the second semiconductor layer stack (102) on the main surface (121) of the second semiconductor layer stack (102),
wherein
- the first semiconductor layer stack (101) is supplied with voltage by the first contact element (112) and the second contact element (114),
- the second semiconductor layer stack (102) is supplied with voltage by the second contact element (114) and the contact element (122) of the second semiconductor layer stack (102),
- the active layer (110) of the first semiconductor layer stack is configured to emit radiation of a first wavelength range, and the active layer (120) of the second semiconductor layer stack is configured to emit radiation of a second wavelength range,
- the separating layer (103) is transparent to radiation of the first wavelength range and is configured to reflect radiation of the second wavelength range, and
- emitted radiation of the first semiconductor layer stack (101) and emitted radiation of the second semiconductor layer stack (102) emerges from the main surface (121) of the second semiconductor layer stack (102).

10. Method according to claim 9, comprising:
- forming at least one recess (104) of the separation layer (103),
- filling the recess (104) of the separation layer (103) with an electrically conductive material.

## Revendications

1. Composant optoélectronique (100) comprenant
- un premier empilement de couches semi-conductrices (101) comprenant une couche active (110) adaptée pour émettre un rayonnement et une surface principale (111),
- une couche de séparation (103) disposée sur la surface principale (111) du premier empilement de couches semi-conductrices, la couche de séparation formant un miroir semi-transparent,
- un deuxième empilement de couches semi-conductrices (102) qui est disposé sur la couche de séparation (103) et qui comprend une autre couche active (120) adaptée pour émettre un rayonnement et une surface principale (121),
comprenant en outre:
- un élément de contact (122) du second empilement de couches semi-conductrices (102) disposé sur la surface principale (121) du second empilement de couches semi-conductrices (102),
- un premier élément de contact (112) du premier empilement de couches semi-conductrices disposé sur une autre surface principale (113) du premier empilement de couches semi-conductrices, l'autre surface principale (113) étant opposée à la surface principale (111),
- un deuxième élément de contact (114) du premier empilement de couches semi-conductrices disposé sur une autre surface principale (115) du premier empilement de couches semi-conductrices dans un évidement du premier empilement de couches semi-conductrices qui s'étend à travers la couche active du premier empilement de couches semi-conductrices, l'autre surface principale (115) étant moins éloignée de la surface principale (111) que l'autre surface principale (113), où
- le premier empilement de couches semi-conductrices (101) est alimenté en tension par le premier élément de contact (112) et le deuxième élément de contact (114),
- le deuxième empilement de couches semi-conductrices (102) est alimenté en tension par le deuxième élément de contact (114) et l'élément de contact (122) du deuxième empilement de couches semi-conductrices (102),
- la couche active (110) du premier empilement de couches semi-conductrices est adaptée pour émettre un rayonnement d'une première plage de longueurs d'onde, et la couche active (120) du second empilement de couches semi-conductrices est adaptée pour émettre un rayonnement d'une seconde plage de longueurs d'onde,
- la couche de séparation (103) est transparente au rayonnement de la première gamme de longueurs d'onde et est adaptée pour réfléchir le rayonnement de la deuxième gamme de longueurs d'onde, **caractérisée en ce que**
- le rayonnement émis du premier empilement de couches semi-conductrices (101) et le rayonnement émis du second empilement de couches semi-conductrices (102) sortent de la surface principale (121) du second empilement de couches semi-conductrices (102).

2. Composant optoélectronique selon la revendication 1, dans lequel la couche de séparation (103) comprend au moins deux couches, les couches présentant au moins deux indices de réfraction différents.

3. Composant optoélectronique selon l'une quelconque des revendications 1 à 2, dans lequel la couche de séparation (103) comprend un matériau électriquement conducteur.

4. Composant optoélectronique selon l'une quelconque des revendications 1 à 2, dans lequel la couche de séparation (103) comprend un diélectrique.

5. Composant optoélectronique selon l'une quelconque des revendications 1 à 4, dans lequel la couche de séparation (103) présente une structuration.

6. Composant optoélectronique selon la revendication 4 ou 5, dans lequel la couche de séparation (103) comprend au moins un évidement (104) dans lequel un matériau électriquement conducteur est inséré.

7. Composant optoélectronique selon l'une quelconque des revendications 1 à 6, dans lequel les différents empilements de couches semi-conductrices (101, 102) peuvent être commandés chacun individuellement.

8. Composant optoélectronique selon l'une quelconque des revendications 1 à 7, comprenant en outre: une substance de conversion (204) pour la conversion partielle de la longueur d'onde du rayonnement, la substance de conversion étant disposée sur la surface principale (121, 221) du deuxième empilement de couches semi-conductrices.

9. Procédé de fabrication d'un composant optoélectronique, comprenant :
- mobiliser un premier substrat (500),
- produire un premier empilement de couches semi-conductrices (501) comprenant une couche active (503) adaptée pour émettre un rayonnement sur le premier substrat,
- détacher un substrat (500) du premier empilement de couches semi-conductrices,
- mobiliser un deuxième substrat (510),
- produire un deuxième empilement de couches semi-conductrices (511) comprenant une couche active (513) appropriée pour l'émission d'un rayonnement sur le deuxième substrat et une surface principale (121),
- détacher un second substrat (510) de l'empilement de couches semi-conductrices,
- le dépôt d'une couche de séparation (505) formant un miroir semi-transparent sur au moins l'un des empilements de couches semi-conductrices,
- l'application du deuxième empilement de couches semi-conductrices (511) sur le premier empilement de couches semi-conductrices (501), de sorte que la couche de séparation (505) est disposée entre le premier et le deuxième empilement de couches semi-conductrices,
- former un évidement dans le premier empilement de couches semi-conductrices s'étendant à travers la couche active,
- former un premier élément de contact (112) et un deuxième élément de contact (114) du premier empilement de couches semi-conductrices (101), le deuxième élément de contact (112) étant disposé dans l'évidement, et
- former un élément de contact (122) du second empilement de couches semi-conductrices (102) sur la surface principale (121) du second empilement de couches semi-conductrices (102),
où
- le premier empilement de couches semi-conductrices (101) est alimenté en tension par le premier élément de contact (112) et le deuxième élément de contact (114),
- le second empilement de couches semi-conductrices (102) est alimenté en tension par le second élément de contact (114) et l'élément de contact (122) du second empilement de couches semi-conductrices (102),
- la couche active (110) du premier empilement de couches semi-conductrices est adaptée pour émettre un rayonnement d'une première plage de longueurs d'onde, et la couche active (120) du second empilement de couches semi-conductrices est adaptée pour émettre un rayonnement d'une seconde plage de longueurs d'onde,
- la couche de séparation (103) est transparente au rayonnement de la première gamme de longueurs d'onde et est adaptée pour réfléchir le rayonnement de la deuxième gamme de longueurs d'onde, et
- rayonnement émis par le premier empilement de couches semi-conductrices (101) et le rayonnement émis par le second empilement de couches semi-conductrices (102) sortent de la surface principale (121) du second empilement de couches semi-conductrices (102).

10. Procédé selon la revendication 9, comprenant :
- former au moins un évidement (104) de la couche de séparation (103),
- rembourrer l'évidement (104) de la couche de séparation (103) avec un matériau électriquement conducteur.
